# EUROPÄISCHE PATENTSCHRIFT

(11) **EP 2 159 907 B1**
(45) Veröffentlichungstag und Bekanntmachung des Hinweises auf die Patenterteilung: **27.03.2013**
(21) Anmeldenummer: 09009960.7
(22) Anmeldetag: 01.08.2009
(51) Int. Cl.: H02J 3/01, H03H 1/00

(54) **Elektrische Filteranordnung**
Electrical filter assembly
Agencement de filtre électrique

(30) Priorität: 27.08.2008 DE 102008039983
(43) Veröffentlichungstag der Anmeldung: 03.03.2010
(73) Patentinhaber: Robert Bosch GmbH, 70469 Stuttgart (DE)
(72) Erfinder: Kugler, Achim, 74417 Gschwend (DE)
(74) Vertreter: Thürer, Andreas

(56) Entgegenhaltungen:
- EP-A1- 0 740 316
- DE-A1- 10 046 917
- DE-A1-102004 052 700
- US-A1- 2007 188 265

## Beschreibung

Die Erfindung betrifft eine elektrische Filteranordnung gemäß dem unabhängigen Anspruch 1.

Zur Erfüllung der einschlägigen EMV (elektromagnetische Verträglichkeit) - Vorschriften sind sogenannte Ein- oder Mehrphasen-Filter aus dem Stand der Technik bekannt. Diese Filter können einstufig oder mehrstufig ausgeführt sein. In diesem Zusammenhang wird beispielsweise das einphasige Filter FN343 der Firma Schaffner genannt. Dieses Filter ist zweistufig ausgeführt und umfasst zwei miteinander verbundene Drosselstufen, wobei jede Drosselstufe einen Ringkern umfasst, welcher mit jeweils zwei Wicklungen versehen ist, wobei die Wicklungen miteinander in Serienschaltung verbunden sind. Das FN343 zeigt eine standardmäßige Verschaltung zweier stromkompensierter Drosseln, wie dies bei zweistufigen oder mehrstufigen Netzfiltern üblich ist. Die stromkompensierten Drosseln bewirken, dass die durch den Nutzstrom erzeugten magnetischen Flüsse der Ringkerne sich gegenseitig kompensieren. Hierdurch wird die Drossel für den Nutzstrom nicht wirksam, sondern nur für Störströme, welche im Gleichtakt auf beide Anschlüsse der Drossel einwirken.

Das Dokument US 2007/188265 offenbart eine elektrische Filteranordnung gemäß des Oberbegriffs des Anspruchs 1.

Die Erfindung geht daher aus von einer elektrischen Filteranordnung mit zumindest zwei miteinander verbundenen Drosselstufen mit jeweils zumindest einer ersten und einer zweiten Wicklung, wobei jede Stufe zumindest ein von der jeweiligen anderen Stufe separates Mittel zur magnetischen Kopplung umfasst, an dem die Wicklungen einer Stufe derart angeordnet sind, dass diese miteinander magnetisch verkoppelt sind. Die Wicklungen einer Stufe sind derart angeordnet, dass sie gegensinnig von einem gemeinsamen Arbeitsstrom durchflossen werden können. Die Mittel zur magnetischen Kopplung beider Stufen können beispielsweise aus nanokristallinem Material hergestellt sein.

Nachteilig bei einer derartigen Anordnung ist, dass die Mittel zur magnetischen Kopplung wegen fehlendem Bauraum in der Regel sehr Nahe beieinander angeordnet werden müssen. Dies kann zu einer gegenseitigen Beeinflussung und Übersättigung der Mittel führen und die Wirksamkeit des Filters reduzieren. Eine reduzierte Wirksamkeit wurde beispielsweise beobachtet durch das regelmäßige ungewollte Auslösen eines FI - Schutzschalters zur Absicherung eines Netzes in Verbindung mit einem Umrichter, an dem ein zuvor genanntes Filter betrieben wurde. Der FI - Schutzschalter wurde ausgelöst, weil die Störströme, die der Umrichter verursacht, nicht mehr über die Zwischenkreiskondensatoren zurück zum Zwischenkreis strömen. Der Strom gelangt zurück in das Versorgungsnetz und von dort wieder zum Umrichterzwischenkreis. Dieser Strom wird von einem FI - Schalter als Fehlerstrom behandelt.

Erfindungsgemäß wird eine erste Wicklung der ersten Drosselstufe mit einer ersten Wicklung der zweiten Drosselstufe und eine zweite Wicklung der ersten Drosselstufe mit einer zweiten Wicklung der zweiten Drosselstufe derart elektrisch verbunden, dass die von einem Arbeitsstrom verursachten Richtungsvektoren des sich innerhalb der Mittel ausbildenden magnetischen Flusses in entgegen gesetzte Richtungen zeigen.

Dies hat den Vorteil, dass die gegenseitige Beeinflussung der Kerne auch bei geringem Abstand reduziert wird, so dass weiterhin kleinstmögliche Bauformen realisierbar sind. Die sonstige Funktion des Filters bleibt dadurch unbeeinflusst. Die Erfindung bewirkt demgemäß eine Verbesserung und Stabilisierung des Filters und verhindert trotz des geringen Bauraüms eine Übersteuerung und damit die Auslösung eines FI-Schutzschalters.

Vorteilhafterweise handelt es sich bei den Mitteln zur magnetischen Kopplung um sogenannte Ringkerne, welche beispielsweise mittels nanokristallinem Material hergestellt wurden. Jede Stufe umfasst einen eigenen Ringkern. Beide Stufen sind derart räumlich zueinander angeordnet, dass die Ringkerne im wesentlichen in einer Ebene unmittelbar benachbart zueinander zum liegen kommen. Es könnte beispielsweise die Länge eines Gehäuses für die erfindungsgemäße Anordnung derart gewählt werden, dass sie in etwa dem doppelten Durchmesser beider Ringkerne entspricht. Auch zueinander winkelig angeordnete Ringkerne (z.B. rechter Winkel) wären denkbar, allerdings müssen die Ringkerne unmittelbar zueinander benachbart sein.

Vorzugsweise wird der erfindungsgemäße Effekt dadurch erreicht, dass sich die Verbindungsleitungen für die Wicklungen benachbarter Drosselstufen kreuzen. Das Ende der ersten Wicklung auf dem ersten Ringkern ist dann mit dem Anfang der ersten Wicklung auf dem zweiten Ringkern verbunden während das Ende der zweiten Wicklung auf dem ersten Ringkern mit dem Anfang der zweiten Wicklung auf dem zweiten Ringkern verbunden ist. Hierdurch entsteht quasi eine Serienschaltung sich diagonal gegenüberliegender Wicklungen. Es ist auch eine Konstruktion denkbar, bei der die Verbindungsleitungen im wesentlichen parallel zueinander ausgerichtet sind. In diesem Falle werden die Drosseln auf der zweiten Drosselstufe um 180 Grad verdreht am Ringkern angeordnet. Man verschaltet somit das Drosselende der ersten Wicklung auf der ersten Stufe mit dem Drosselende der ersten Wicklung auf der zweiten Stufe. Gleiches gilt für die zweite Wicklung auf der ersten und zweiten Stufe. Der Wicklungssinn der Wicklungen auf beiden Ringkernen ist damit jeweils umgekehrt.

Vorzugsweise ist zwischen den beiden Drosselstufen und/oder zwischen der ersten und der zweiten Wicklung jeder Drosselstufe zumindest eine Kapazität angeordnet. Diese Kapazitäten können beispielsweise am Eingang und/oder am Ausgang der Drosseln angebracht sein. Die Kapazitäten können zwischen mehreren Phasen bei mehrphasigen Lösungen angeordnet werden oder sie können zwischen einer Phase und dem Erdleiter angeordnet werden. Mittels der Kapazitäten wird in erster Linie der Frequenzgang beeinflusst. Beispielsweise ist es möglich einen Tiefpassfilter zu realisieren, welcher Störungen oder Pulsströme mit hohen Frequenzen ausfiltert und tiefere Frequenzen passieren lässt.

Ein Kondensator könnte beispielsweise auch als Abstandshalter zwischen zwei Ringkernen fungieren, so dass der Abstand zwischen zwei Drosselstufen durch die Abmessungen des Kondensatorgehäuses definiert ist. Zusätzliche Abstandshalter oder Abstandsmittel entfallen dadurch. Aufgrund des hiermit erreichten erhöhten Abstandes zwischen beiden Ringkernen wird zusätzlich die Beeinflussung beider Ringkerne verringert.

Vorzugsweise ist die erfindungsgemäße Vorrichtung bzw. Anordnung kaskadierbar realisiert, so dass beispielsweise auch eine dritte oder vierte Drosselstufe mit jeweils einem eigenen Mittel zur magnetischen Kopplung und entsprechenden Wicklungen in Serie zu der vorhandenen Anordnung geschaltet werden kann. Auch ist es möglich, die erfindungsgemäße Vorrichtung nicht nur für eine elektrische Phase, sondern für zwei, drei oder mehr elektrische-Phasen zu realisieren.

Vorzugsweise wird mittels der erfindungsgemäßen Lösung eine Apparatur realisiert, welche Apparatur eine elektrische Filteranordnung und ein Gehäuse umfasst, wobei zumindest jeweils ein Wicklungsende beider Wicklungen einer Drosselstufe von außerhalb des Gehäuses zugänglich ist. Zur Reduzierung elektromagnetischer Störstrahlungen kann das Gehäuse die erfindungsgemäße Filteranordnung vollständig umschließen (Faraday-Käfig) und zusätzlich geerdet werden. Die Apparatur kann somit als eigenständige elektrische Komponente hergestellt und vertrieben und in jegliche denkbare elektrische Vorrichtung als Netzfilter eingebaut werden. Für einen unkomplizierten Einbau können die zuvor erwähnten und nach Außen geführten Wicklungsenden mit Lötfahnen oder Steckvorrichtungen versehen werden. Die Apparatur kann somit in die Versorgungszuleitung eines elektrischen Gerätes eingebaut werden.

Vorteilhafterweise wird die erfindungsgemäße elektrische Filteranordnung im Umfeld einer Drossel und/oder eines Netzfilters und/oder eines Umrichters in Verbindung mit einem mittels einer Überstromschutzeinrichtung (z.B. FI-Schalter) versehenden elektrischen Netzes betrieben. Mittels der erfindungsgemäßen Lösung kann vermieden werden, dass die Überstromschutzeinrichtung frühzeitig oder ungewollt durch Spannungsspitzen oder Pulsströme ausgelöst wird.

Nachfolgende Ausführungsbeispiele schränken die erfindungsgemäße Lösung in keiner Weise ein. Es handelt sich lediglich um beispielhafte mögliche Anwendungen der Erfindung in Verbindung mit einem Ringkern. Jegliche anderen denkbaren Mittel zur Magnetfeldkanalisierung sind ebenfalls zur Realisierung denkbar.

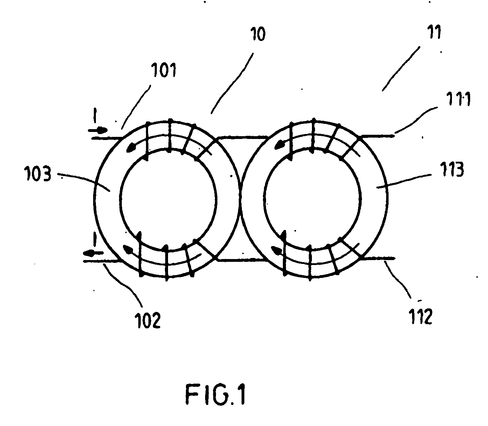

Figur 1 zeigt ein als Ringkern 103 ausgebildetes erstes Mittel zur Kanalisierung eines Magnetfeldes, an dem jeweils eine erste Wicklung 101 und eine zweite Wicklung 102 angeordnet sind. Beide Wicklungen 101, 102 sind sich gegenüberliegend am Ringkern (103) angeordnet. Diese Anordnung bildet die erste Stufe 10 eines Filters.

Weiter ist gezeigt ein als Ringkern 113 ausgebildetes zweites Mittel zur Kanalisierung eines Magnetfeldes, an dem ebenfalls jeweils eine erste Wicklung 111 und eine zweite Wicklung 112 angeordnet sind. Wie beim ersten Ringkern 103 sind auch hier die beiden Wicklungen 111, 112 sich gegenüberliegend angeordnet. Diese Anordnung bildet die zweite Stufe 11 eines Filters.
Die Stufen 10, 11 sind hier in Serie geschaltet und zeigen eine aus dem Stand der Technik bekannte Lösung. Der Wicklungssinn der Wicklungen (101, 102 bzw. 111, 112) ist jeweils gegensinnig.

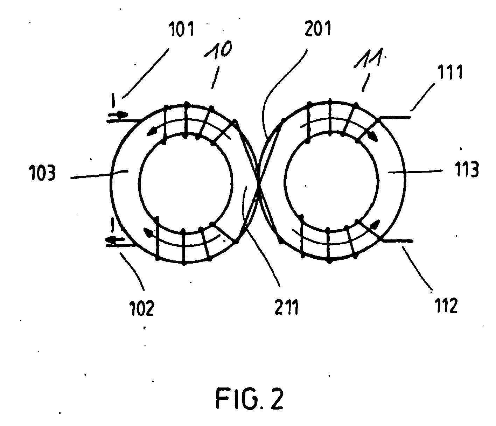

Figur 2 zeigt die erfindungsgemäße Lösung. Wie in Figur 1 ist auch hier ein zweistufiges 10,11 Filter gezeigt. Der Unterschied zu der in Figur 1 gezeigten Lösung besteht jedoch darin, dass die Wicklung 101 am ersten Ringkern 103 mit der Wicklung 112 am zweiten Ringkern 113 verbunden ist und dass die Wicklung 102 am ersten Ringkern 103 mit der Wicklung 111 am zweiten Ringkern 113 verbunden ist. Die Wicklungen 101 und 112 bzw. 102 und 111 liegen sich jeweils diametral gegenüber.

Zur erfindungsgemäßen Realisierung wurden sich überkreuzende Verbindungsleitungen 201, 211 verwendet. Beide Leitungen 201, 211 überkreuzen sich in etwa an der Stelle, wo sich beide Ringkerne berühren bzw. ihren kleinsten Abstand zueinander haben. Diese Art der elektrischen Kopplung beider Filterstufen 10, 11 bewirkt, dass sich die Vektoren der magnetischen Flussdichte innerhalb eines Ringkerns 103, 113 im wesentlichen neutralisieren. Der zusätzliche erfindungsgemäße Effekt liegt darin, dass die gegenseitige Beeinflussung der Filterstufen 10, 11 gegenüber den bekannten Lösungen reduziert wird.

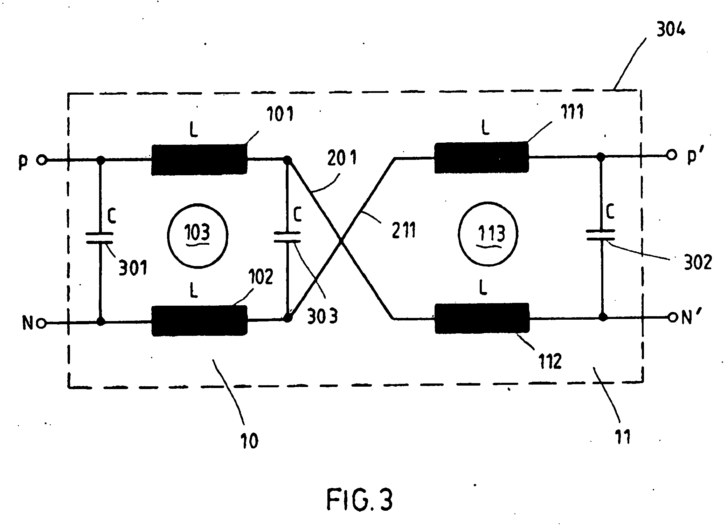

Figur 3 zeigt eine erfindungsgemäße Apparatur umfassend ein Gehäuse 304, in dem eine elektrische Filteranordnung wie zuvor in Verbindung mit Figur 2 beschrieben angeordnet ist. Zumindest jeweils ein Anschluss der Wicklungen 101, 102, 111, 112 zweier miteinander verbundener Drosselstufen 10, 11 ist von außerhalb des Gehäuses 304 zugänglich. Der Zugang ist mittels der Anschlüsse (Lötfahnen, Buchsen, Klemmen) P, P' bzw. N, N' realisiert. Zwischen den sich beiden Gehäuseseiten gegenüberliegenden Anschlüssen P, P' bzw. N, N' ist das erfindungsgemäße Filter realisiert. Von links betrachtet führt zunächst der Anschluss P auf eine Induktivität 101 und auf eine Kapazität 301: Der Anschluss N führt ebenfalls auf eine Induktivität 102 und dieselbe Kapazität 301, welche sich zwischen beiden Anschlüssen P und N befindet. Die Induktivitäten 101 und 102 sind zwischen der zuvor genannten Kapazität 301 und einer weiteren Kapazität 303 angeordnet. Die Induktivität 101 der ersten Stufe 10 ist mit der Induktivität 112 der zweiten Stufe 11 und die Induktivität 102 er ersten Stufe 10 ist mit der Induktivität 111 der zweiten Stufe 11 verbunden. Zwischen beiden Induktivitäten 111 und 112 der zweiten Stufe 11 ist ausgangsseitig ebenfalls eine Kapazität 302 vorgesehen. Die Induktivitäten 111 und 112 sind kreuzweise zwischen den Kapazitäten 302 und 303 angeordnet.

Der Ausgang P' der erfindungsgemäßen Anordnung ist mit der Induktivität 111 und der Kapazität 302 verbunden, wohingegen der Ausgang N' mit der Induktivität 112 und der Kapazität 302 verbunden ist. Die Kapazität 302 liegt ausgangsseitig schaltungstechnisch zwischen beiden Induktivitäten 111, 112. Die Induktivitäten 101, 102 der ersten Stufe 10 und die Induktivitäten 111 und 112 der zweiten Stufe 11 sind jeweils auf den Ringkernen 103 bzw. 113 angeordnet. Die Ringkerne 103, 113 liegen flächig auf dem Gehäuseboden und sind unmittelbar zueinander benachbart, ohne dass sie sich überlappen. Die gesamte Anordnung ist von dem Gehäuse 304 vollständig umschlossen. Das Gehäuse wirkt als Faraday-Käfig und ist geerdet. Mittels der Anschlüsse P, P' und N, N' kann das Gehäuse leicht zwischen ein Netz mit FI-Schalter und ein elektrisches Gerät geschaltet werden.

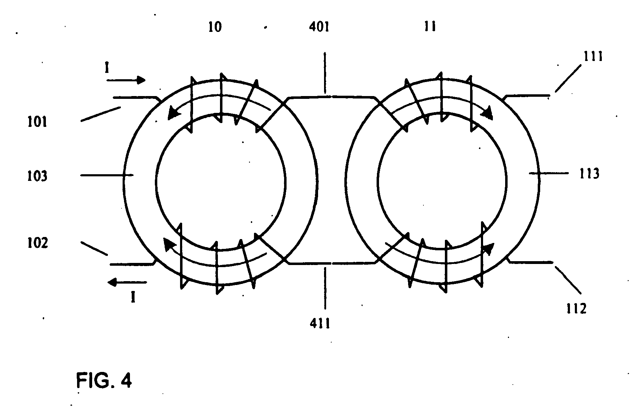

Figur 4 zeigt eine zweistufige Lösung wie in den Figuren 1 und 2 beschrieben. Die Verbindungsleitungen 401, 411 zwischen den Wicklungen 101, 102, 111, 112 der Drosselstufen 10,11 sind parallel zueinander ausgerichtet und die Wicklungen 101, 102 der ersten Stufe 10 haben einen entgegen gesetzten Wicklungssinn zu den Wicklungen 111,112 der zweiten Stufe 11 mit denen sie verbunden sind. Es handelt sich hierbei um eine Alternativlösung zu der in Figur 2 gezeigten Lösung.

Bei der Verschaltung der Drosseln gemäß Figur 1 entstehen gleichsinnige Streufelder. Ein vom ersten Ringkern verursachtes Streufeld kann sich in den zweiten Kern einkopplen und hier für eine nicht gewollte Grundaussteuerung bewirken, was letzlich zu frühzeitiger Übersättigung führen kann, wenn beispielsweise weitere austeuernde Ströme hinzukommen. Bei Übersättigung geht das induktive Verhalten der Anordnung verloren und die Wicklungen arbeiten dann nur noch als Luftspule.

Die Erfindung verbessert das Verhalten des Netzfilters im Grenzbereich der Übersteuerung und ist sowohl für einphasige als auch für mehrphasige Anordnungen geeignet.

## Patentansprüche

1. Elektrische Filteranordnung mit zumindest zwei miteinander verbundenen Drosselstufen (10,11) mit jeweils zumindest einer ersten und einer zweiten Wicklung (101,102,111,112), wobei jede Stufe (10, 11) zumindest ein von der jeweils anderen Stufe separates Mittel (103,113) zur magnetischen Kopplung umfasst, an dem die Wicklungen (101,102,111,112) einer jeden Stufe (10, 11) derart angeordnet sind, dass diese miteinander magnetisch verkoppelbar sind und dass sie gegensinnig von einem gemeinsamen Arbeitsstrom durchflossen werden können,
**dadurch gekennzeichnet, dass**
eine erste Wicklung (101,102) der ersten Drosselstufe (10) mit einer ersten Wicklung (111,112) der zweiten Drosselstufe (11) und eine zweite Wicklung (101,102) der ersten Drosselstufe (10) mit einer zweiten Wicklung (111,112) der zweiten Drosselstufe (11) derart elektrisch verbunden (201,211) ist, dass die Richtungsvektoren eines sich innerhalb beider Mittel (10,11) ausbildenden magnetischen Flusses, welcher mittels eines von den elektrisch miteinander verbundenen Wicklungen (101,102,111,112) geführten Arbeitsstromes verursacht werden kann, in entgegen gesetzte Richtungen zeigen.

2. Elektrische Filteranordnung nach Anspruch 1, wobei die Mittel zur magnetischen Kopplung Ringkerne (103, 113) sind, welche auf im wesentlichen einer gemeinsamen räumlichen Ebene unmittelbar benachbart zueinander angeordnet sind.

3. Elektrische Filteranordnung nach Anspruch 1, wobei die Mittel zur magnetischen Kopplung Ringkerne (103,113) sind, wobei jeder Ringkern (103,113) auf einer separaten räumlichen Ebene angeordnet ist und wobei die Ringkerne (103,113) unmittelbar benachbart zueinander angeordnet sind.

4. Elektrische Filteranordnung nach einem der vorhergehenden Ansprüche, wobei sich die Verbindungsleitungen (201, 211) für die Wicklungen (101, 112, 102, 111) benachbarter Drosselstufen (10,11) kreuzen.

5. Elektrische Filteranordnung nach einem der vorhergehenden Ansprüche, wobei die Verbindungsleitungen (401, 411) für die Wicklungen (101,112,102,111) benachbarter Drosselstufen (10,11) im wesentlichen parallel zueinander ausgerichtet sind.

6. Elektrische Filteranordnung nach einem der vorhergehenden Ansprüche, wobei zwischen den beiden Drosselstufen (10,11) und/oder zwischen der ersten und der zweiten Wicklung (101,102,111,112) einer Drosselstufe (10,11) zumindest eine Kapazität (301, 302, 303) angeordnet ist.

7. Elektrische Filteranordnung nach Anspruch 6, wobei der Abstand zwischen beiden Drosselstufen (10,11) durch die Abmessung des Gehäuses einer Kapazität (301, 302, 303) bestimmt ist.

8. Elektrische Filteranordnung nach einem der vorhergehenden Ansprüche, wobei diese kaskadierbar und zu einer mehrstufigen Anordnung ausbaubar ist.

9. Elektrische Filteranordnung nach einem der vorhergehenden Ansprüche, wobei diese für mehrere Phasen eines Energieversorgungsnetzes ausgelegt ist.

10. Apparatur umfassend ein Gehäuse (304), in dem eine elektrische Filteranordnung nach einem der vorhergehenden Ansprüche angeordnet ist, wobei zumindest jeweils eine der Wicklungen (101, 102, 111, 112) zweier Drosselstufen (10,11) von außerhalb des Gehäuses (304) zugänglich ist.

11. Drossel mit elektrischer Filteranordnung gemäß einem der vorherigen Ansprüche.

12. Netzfilter mit elektrischer Filteranordnung gemäß einem der vorherigen Ansprüche.

13. Umrichter mit elektrischer Filteranordnung gemäß einem der vorherigen Ansprüche.

14. Elektrisches Gerät, insbesondere Kompaktsteuerung für Schraubsysteme, mit elektrischer Filteranordnung gemäß einem der vorherigen Ansprüche 1 bis 9, welches mit einem elektrischen Netz umfassend einen Überstromschutzschalter elektrisch verbunden ist.

15. Elektrisches Versorgungsnetz mit elektrischer Filteranordnung gemäß einem der vorherigen Ansprüche 1 bis 9 und mit Überstromschutzschalter, wobei der Überstromschutzschalter und die Filteranordnung miteinander elektrisch miteinander verbunden sind.

## Claims

1. Electrical filter arrangement having at least two throttle stages (10, 11) which are connected to one another and in each case have at least a first and a second winding (101, 102, 111, 112), with each stage (10, 11) comprising at least one means (103, 113), which is separate from the respectively other stage, for magnetic coupling, on which means the windings (101, 102, 111, 112) of each stage (10, 11) are arranged in such a way that they can be magnetically coupled to one another and that a common working flow can flow through them in opposite directions,
**characterized in that**
a first winding (101, 102) of the first throttle stage (10) is electrically connected (201, 211) to a first winding (111, 112) of the second throttle stage (11) and a second winding (101, 102) of the first throttle stage (10) is electrically connected (201, 211) to a second winding (111, 112) of the second throttle stage (11) in such a way that the directional vectors of a magnetic flux which forms within the two means (10, 11), which magnetic flux can be caused by means of a working flow which is guided by the windings (101, 102, 111, 112) which are electrically connected to one another, point in opposite directions.

2. Electrical filter arrangement according to Claim 1, with the means for magnetic coupling being toroidal cores (103, 113) which are arranged directly adjacent to one another on essentially a common physical plane.

3. Electrical filter arrangement according to Claim 1, with the means for magnetic coupling being toroidal cores (103, 113), with each toroidal core (103, 113) being arranged on a separate physical plane, and with the toroidal cores (103, 113) being arranged directly adjacent to one another.

4. Electrical filter arrangement according to one of the preceding claims, with the connecting lines (201, 211) for the windings (101, 112, 102, 111) of adjacent throttle stages (10, 11) intersecting.

5. Electrical filter arrangement according to one of the preceding claims, with the connecting lines (401, 411) for the windings (101, 112, 102, 111) of adjacent throttle stages (10, 11) being oriented substantially parallel to one another.

6. Electrical filter arrangement according to one of the preceding claims, with at least one capacitor (301, 302, 303) being arranged between the two throttle stages (10, 11) and/or between the first and the second winding (101, 102, 111, 112) of a throttle stage (10, 11).

7. Electrical filter arrangement according to Claim 6, with the distance between the two throttle stages (10, 11) being determined by the dimensions of the housing of a capacitor (301, 302, 303).

8. Electrical filter arrangement according to one of the preceding claims, it being possible to cascade the said electrical filter arrangement and to reconstruct the said electrical filter arrangement to form a multistage arrangement.

9. Electrical filter arrangement according to one of the preceding claims, with said electrical filter arrangement being designed for a plurality of phases of a power supply system.

10. Apparatus comprising a housing (304) in which an electrical filter arrangement according to one of the preceding claims is arranged, with at least in each case one of the windings (101, 102, 111, 112) of two throttle stages (10, 11) being accessible from outside the housing (304).

11. Throttle having an electrical filter arrangement according to one of the preceding claims.

12. Supply system filter having an electrical filter arrangement according to one of the preceding claims.

13. Converter having an electrical filter arrangement according to one of the preceding claims.

14. Electrical appliance, in particular compact controller for screwing systems, having an electrical filter arrangement according to one of the preceding Claims 1 to 9 which is electrically connected to an electrical supply system comprising an overcurrent circuit breaker.

15. Electrical supply system having an electrical filter arrangement according to one of the preceding Claims 1 to 9 and having an overcurrent circuit breaker, with the overcurrent circuit breaker and the filter arrangement being electrically connected to one another.

## Revendications

1. Agencement de filtre électrique doté d'au moins deux étages d'étranglement (10, 11) reliés entre eux avec respectivement au moins un premier et un deuxième enroulement (101, 102, 111, 112), chaque étage (10, 11) comprenant au moins un moyen (103, 113) de couplage magnétique séparé de l'autre étage respectivement et au niveau duquel les enroulements (101, 102, 111, 112) de chaque étage (10, 11) sont disposés de telle sorte que ceux-ci peuvent être couplés sur le plan magnétique et qu'ils peuvent être traversés en sens contraire par un courant de travail commun ;
**caractérisé en ce que** :
un premier enroulement (101, 102) du premier étage d'étranglement (10) est relié sur le plan électrique (201, 211) à un premier enroulement (111, 112) du deuxième étage d'étranglement (11) et un deuxième enroulement (101, 102) du premier étage d'étranglement (10) est relié sur le plan électrique (201, 211) à un deuxième enroulement (111, 112) du deuxième message d'étranglement (11) de telle sorte que les vecteurs de direction d'un courant magnétique se formant à l'intérieur des deux moyens (10, 11) et pouvant être provoqués à l'aide d'un courant de travail guidé par les enroulements (101, 102, 111, 112) reliés entre eux sur le plan électrique pointent dans des directions opposées.

2. Agencement de filtre électrique selon la revendication 1, les moyens de couplage magnétique étant des noyaux annulaires (103, 113) disposés dans un plan pour l'essentiel commun, à proximité immédiate les uns des autres.

3. Agencement de filtre électrique selon la revendication 1, les moyens de couplage magnétique étant des noyaux annulaires (103, 113), chaque noyau annulaire (103, 113) étant disposé dans un plan séparé et les noyaux annulaires (103, 113) étant disposés à proximité immédiate les uns des autres.

4. Agencement de filtre électrique selon l'une quelconque des revendications précédentes, les câbles de liaison (201, 211) des enroulements (101, 112, 102, 111) croisant les étages d'étranglement (10, 11) connexes.

5. Agencement de filtre électrique selon l'une quelconque des revendications précédentes, les câbles de liaison (401, 411) des enroulements (101, 112, 102, 111) des étages d'étranglement (10, 11) connexes étant orientés pour l'essentiel parallèlement les uns par rapport aux autres.

6. Agencement de filtre électrique selon l'une quelconque des revendications précédentes, au moins une résistance (301, 302, 303) étant disposée entre les deux étages d'étranglement (10, 11) et/ou entre le premier et le deuxième enroulement (101, 102, 111, 112) d'un étage d'étranglement (10, 11).

7. Agencement de filtre électrique selon la revendication 6, la distance entre les deux étages d'étranglement (10, 11) étant définie par la dimension de l'enveloppe d'une résistance (301, 302, 303).

8. Agencement de filtre électrique selon l'une quelconque des revendications précédentes, celui-ci pouvant être réalisé en cascade et pouvant être aménagé de façon à former un agencement à plusieurs étages.

9. Agencement de filtre électrique selon l'une quelconque des revendications précédentes, celui-ci étant conçu pour plusieurs phases d'un réseau d'alimentation électrique.

10. Appareil comprenant un carter (304) dans lequel un agencement de filtre électrique selon l'une quelconque des revendications précédentes est disposé, au moins respectivement un des enroulements (101, 102, 111, 112) des deux étages d'étranglement (10, 11) étant accessible depuis l'extérieur du carter (304).

11. Étranglement doté d'un agencement de filtre électrique selon l'une quelconque des revendications précédentes.

12. Filtre de réseau doté d'un agencement de filtre électrique selon l'une quelconque des revendications précédentes.

13. Convertisseur doté d'un agencement de filtre électrique selon l'une quelconque des revendications précédentes.

14. Appareil électrique, notamment commande compacte pour systèmes de vissage, doté d'un agencement de filtre électrique selon l'une quelconque des revendications 1 à 9, relié sur le plan électrique à un réseau électrique comprenant un commutateur de protection contre les surtensions.

15. Réseau d'alimentation électrique doté d'un agencement de filtre électrique selon l'une quelconque des revendications 1 à 9 et doté d'un commutateur de protection contre les surtensions, le commutateur de protection contre les surtensions et l'agencement de filtre étant reliés entre eux sur le plan électrique.
